# EUROPEAN PATENT SPECIFICATION

(11) **EP 2 392 628 B1**
(45) Date of publication and mention of the grant of the patent: **21.08.2013**
(21) Application number: 10735700.6
(22) Date of filing: 13.01.2010
(51) Int. Cl.: C09J 133/00, C08K 3/38, C09J 7/00, C09J 11/04, C09J 133/08, C09J 7/02

(54) **HEAT-CONDUCTIVE PRESSURE-SENSITIVE ADHESIVE COMPOSITION AND HEAT-CONDUCTIVE PRESSURE-SENSITIVE ADHESIVE SHEET**
WÄRMELEITENDE HAFTKLEBERZUSAMMENSETZUNG UND WÄRMELEITENDE HAFTKLEBEFOLIE
COMPOSITION D'AGENT ADHÉSIF THERMOCONDUCTRICE ET FEUILLE ADHÉSIVE THERMOCONDUCTRICE

(30) Priority: 30.01.2009 JP 2009019959
(43) Date of publication of application: 07.12.2011
(73) Proprietor: Nitto Denko Corporation, Ibaraki-shi Osaka 567-8680 (JP)
(72) Inventor: NAKAYAMA, Junichi, Ibaraki-shi Osaka 567-8680 (JP); TERADA, Yoshio, Ibaraki-shi Osaka 567-8680 (JP); FURUTA, Kenji, Ibaraki-shi Osaka 567-8680 (JP); WANO, Takashi, Ibaraki-shi Osaka 567-8680 (JP)
(74) Representative: Stolmár & Partner
(86) International application number: PCT/JP2010/050291
(87) International publication number: WO 2010/087230

(56) References cited:
- EP-A2- 1 184 899
- WO-A2-2008/042446
- JP-A- 11 181 368
- JP-A- 2001 348 488
- JP-A- 2002 322 449
- JP-A- 2003 049 144
- JP-A- 2003 105 299
- JP-A- 2005 320 484
- JP-A- 2005 343 728
- JP-A- 2005 343 983
- JP-A- 2008 189 818

## Description

### TECHNICAL FIELD

The present invention relates to a heat conductive adhesive composition containing boron nitride particles and an acrylic polymer component and to a heat conductive adhesive sheet using the heat conductive adhesive composition.

### BACKGROUND ART

Fillers have been conventionally contained in a resin composition to improve the strength and enhance the heat conductivity compared with a base resin alone.
Particularly, a heat conductive adhesive resin composition, wherein an inorganic filler for enhanced heat conductivity is dispersed in a base resin in which an epoxy resin is used, is commonly used in electronic components such as sealing chip parts, forming an insulating layer between a heat sink and a circuit on which a heat generating part is mounted.
For example, Patent Document 1 describes a heat conductive adhesive sheet with a metallic foil, wherein a high heat conductive resin layer formed in the form of sheet using a heat conductive adhesive composition containing a filler and a polymer component such as a thermoplastic resin and a heat curable resin is laminated on a metallic foil layer formed using a metallic foil (hereinafter also referred to as "a metallic foil-clad high heat conductive adhesive sheet"), and that such a metallic foil-clad high heat conductive adhesive sheet is used to bond a semiconductor chip.

Since the heat conductive adhesive composition is usually required to have good heat conductivity, an inorganic nitride having good heat conductivity such as boron nitride and aluminum nitride is used as the filler contained, and it has been conventionally studied to fill a large amount of such a filler in a heat conductive adhesive composition.
For example, Patent Document 2 describes that the heat conductivity of a heat conductive adhesive composition can be 3 to 10 W/mK when a filler having a predetermined particle size distribution is filled in a polymer component such as an epoxy resin in a proportion as high as 80 to 95% by mass.

However, although Patent Document 2 shows Examples in which fillers such as boron nitride particles and magnesium oxide particles are used, all Examples only show these fillers used together with aluminum oxide particles or aluminum nitride particles.
Further, the above literature describes only Examples in which aluminum oxide particles and aluminum nitride particles are mainly used, and fillers such as boron nitride particles and magnesium oxide particles are used only in a smaller amount than aluminum oxide particles and aluminum nitride particles.

Boron nitride has been increasingly used as a filler lately due to good heat conductivity thereof.
The boron nitride particles used as a filler is naturally scale shaped, and commercial products are limited to those having a particle size of as small as several micrometers to ten and several micrometers.
Some commercial products are particles obtained by aggregation of such scale-shaped particles, and a whole granular aggregate wherein the scaly structure of the original particle is no longer distinguished (hereinafter also referred to as "granular particle") and a coagulate under coagulated condition to the extent that an individual particle is distinguished (hereinafter also referred to as "collective particle") are sold commercially as fillers.
Although the aluminum oxide particle mainly studied in Patent Document 2 is commercially available as a large number of products of particles that are similar in shape and different only in size and it is easy to obtain a particle having a desirable particle size, only particles having a particle size of several tens micrometers to several hundred micrometers, even as aggregated particles as described above, are commercially available for the boron nitride.

For this reason, it is difficult to employ the method described in Patent Document 2 when particles having different shapes depending on particle sizes such as the boron nitride particle are used.
For adding such a boron nitride particle to a heat conductive adhesive composition, conditions for adding the filler must be reconsidered so as to improve the heat conductivity of a molding.
However, the use of boron nitride particle has not been thoroughly studied or no suitable conditions have been found so far.
More specifically, conventional heat conductive adhesive compositions containing a polymer component and a filler using boron nitride particles (boron nitride filler) pose a problem of having difficulty in sufficiently enhancing the heat conductivity of a molding such as a heat conductive adhesive sheet.

To the contrary, Patent Document 3 describes that heat conductivity can be improved by defining the particle size distribution of boron nitride used in a heat conductive resin composition containing a polymer component and boron nitride particles.
However, the heat conductive resin composition described in Patent Document 3 contains an epoxy resin as the polymer component.
Owing to this reason, the heat conductive resin composition of Patent Document 3 has good heat conductivity but is not adhesive at room temperature, hence not adherable under pressure sensitive conditions.
Consequently, when such a composition is used for the purpose of fixing chip parts to a heat sink and an enclosure, for example, it is difficult to easily bond and fix the parts.

That is, a heat conductive resin composition having adhesion strength (hereinafter also referred to as "heat conductive adhesive composition") with good heat conductivity has not yet been attained, and a heat conductive adhesive sheet made of a heat conductive adhesive composition in the form of sheet having good adhesive property (pressure sensitive bond strength) and heat conductivity has not yet been obtained.

### PRIOR ART DOCUMENT

### PATENT DOCUMENT

Patent Document 1: Japanese Patent Application Laid-Open No. Hei-11-186473
Patent Document 2: Japanese Patent Application Laid-Open No. 2001-348488
Patent Document 3: Japanese Patent Application Laid-Open No. 2008-189818

### SUMMARY OF THE INVENTION

### PROBLEMS TO BE SOLVED BY THE INVENTION

The present invention has been accomplished in the light of the above problems, and an object of the invention is to provide a heat conductive adhesive composition containing boron nitride particles and an acrylic polymer component and being capable of forming a molding having good heat conductivity. Another object is to provide a heat conductive adhesive sheet having good heat conductivity and bond strength using the heat conductive adhesive composition.
JP 2003 105299 discloses a heat conductive pressure sensitive adhesive, a heat conductive pressure sensitive adhesive sheet and a laminate using the sheet. The adhesive comprises (a) a copolymer which contains an alkyl acrylate having a 2-18C alkyl group, (b) a compound which is not compatible with the copolymer (a) and has a melting point of 40-80 °C and (c) a heat conductive particulate.

### MEANS FOR SOLVING THE PROBLEMS

The present inventors have found that good bond strength (adhesive properties) can be imparted to a heat conductive adhesive composition by using boron nitride particles and an acrylic polymer component.
Further, with special attention to the relation between the particle size of boron nitride particles in the heat conductive adhesive composition and the heat conductivity of a molding with the heat conductive adhesive composition therein, the inventors conducted extensive research and found that a heat conductive adhesive composition capable of enhancing the heat conductivity of a molding when boron nitride particles with a predetermined particle size distribution are contained in the heat conductive adhesive composition, whereby the present invention has been accomplished.

More specifically, the present invention provides, to solve the above problems, a heat conductive adhesive composition comprising boron nitride particles and an acrylic polymer component, wherein boron nitride particles having a particle size of 3 µm or more and 300 µm or less are contained as the boron nitride particles, and wherein the boron nitride particles having a particle size of 3 µm or more and 300 µm or less contain boron nitride particles having a particle size of 3 µm or more and 20µm or less at the ratio of 5 to 45% by volume, boron nitride particles having a particle size of more than 20 µm and 60 µm or less at the ratio of 30 to 70 % by volume, and boron nitride particles having a particle size of more than 60 µm and 300 µm or less at the ratio of 10 to 40 % by volume.

The present invention further provides a heat conductive adhesive sheet having an adhesive layer formed of the above heat conductive adhesive composition. The heat conductive adhesive sheet includes at least an adhesive layer formed using a heat conductive adhesive composition, the heat conductive adhesive composition comprising boron nitride particles and an acrylic polymer component, wherein boron nitride particles having a particle size of 3 µm or more and 300 µm or less are contained as the boron nitride particles, the boron nitride particles having a particle size of 3µm or more and 300 µm or less contain boron nitride particles having a particle size of 3 µm or more and 20 µm or less at the ratio of 5 to 45 % by volume, boron nitride particles having a particle size of more than 20 µm and 60 µm or less at the ratio of 30 to 70% by volume, and boron nitride particles having a particle size of more than 60 µm and 300 µm or less at the ratio of 10 to 40 % by volume.

As used herein, the term "boron nitride particle" is intended to encompass all particles including, for example, a scale-shaped particle, an aggregated granular particle and a collective particle of such a shaped particle.

### ADVANTAGES OF THE INVENTION

According to the present invention, since boron nitride particles having a particle size of 3 µm or more and 300 µm or less are contained in a heat conductive adhesive composition and the boron nitride particles having a particle size of 3 µm or more and 300 µm or less contain boron nitride particles having a particle size of 3 µm or more and 20 µm or less at the ratio of 5 to 45 % by volume, boron nitride particles having a particle size of more than 20 µm and 60 µm or less at the ratio of 30 to 70 % by volume, and boron nitride particles having a particle size of more than 60 µm and 300 µm or less at the ratio of 10 to 40 % by volume, when a molding such as a heat conductive adhesive sheet using such a heat conductive adhesive composition is formed, the above particle size distribution condition of the boron nitride particles can be reflected in the molding, thereby imparting good heat conductivity to the molding.

### DETAILED DESCRIPTION OF THE PREFERRED EMBODIMENTS

Hereinafter, preferred embodiments of the present invention are described with reference to the heat conductive adhesive sheet made of the heat conductive adhesive composition in the form of sheet.

Examples of the above heat conductive adhesive sheet include a substrate-equipped heat conductive adhesive sheet in which an adhesive layer using the above heat conductive adhesive composition is formed on a sheet substrate such as a resin film and a heat conductive adhesive sheet in which a heat conductive adhesive composition itself is sheet-shaped with an adhesive layer formed of the heat conductive adhesive composition not supported by a substrate.

In the present invention, the heat conductive adhesive composition described above contains a boron nitride filler and an acrylic polymer component.

As the acrylic polymer component any acrylic polymer commonly used can be used.

The acrylic polymer used in the heat conductive adhesive composition of the present invention contains as a monomer unit a (meth)acrylic monomer represented by the following Formula (1).

[Chemical Formula 1] CH₂ = C(R¹)COOR² (1)

wherein R¹ is hydrogen or a methyl group, and R² is an alkyl group having 2 to 14 carbon atoms.

In the above Formula (1), R¹ is hydrogen or a methyl group.
Further, in the above Formula (1), R² is an alkyl group having 2 to 14 carbon atoms, preferably 3 to 12 carbon atoms, more preferably 4 to 9 carbon atoms.
Furthermore, the alkyl group represented by R² may be linear or branched, with branched being preferable with respect to reducing a glass transition point of the acrylic polymer.

Specific examples of the (meth)acrylic monomer represented by Formula (1) include ethyl (meth)acrylate, n-butyl (meth)acrylate, s-butyl (meth)acrylate, t-butyl (meth)acrylate, isobutyl (meth)acrylate, n-pentyl (meth)acrylate, isopentyl (meth)acrylate, hexyl (meth)acrylate, heptyl (meth)acrylate, isoamyl (meth)acrylate, 2-ethyl hexyl (meth)acrylate, n-octyl (meth)acrylate, isooctyl (meth)acrylate, n-nonyl(meth)acrylate, isononyl (meth)acrylate, n-decyl (meth)acrylate, isodecyl (meth)acrylate, n-dodecyl (meth)acrylate, isomyristyl (meth)acrylate, n-tridecyl (meth)acrylate, n-tetradecyl (meth)acrylate, stearyl (meth)acrylate, isostearyl (meth)acrylate, and phenoxyethyl (meth)acrylate.

In the present invention, the (meth)acrylic monomers represented by the above-described Formula (1) may be used singly or in mixture of two or more thereof, but the total content thereof in the entire monomers of the acrylic polymer is 50 to 98% by weight, preferably 60 to 98% by weight, more preferably 70 to 90% by weight.
When a content of the above (meth)acrylic monomer is less than 50% by weight, the bond properties become poor, hence not desirable.

In one embodiment, the heat conductive adhesive composition 0.2% by weight or more and 20% by weight or less of monomer constituting the acrylic polymer has a polar group. The above acrylic polymer contains, as a monomer unit, preferably 0.1 to 20% by weight, more preferably 0.2 to 10% by weight of a polar group-containing monomer such as a hydroxyl group-containing monomer or a carboxyl group-containing monomer.
Particularly, it is preferred to contain 0.2 to 7% by weight of polar group-containing monomers.
When the above polar group-containing monomer is contained in an amount within the above range, a higher intermolecular cohesive force can be generated.
To the contrary, when a content of the above polar group-containing monomer exceeds 20% by weight, the bond properties may be deteriorated.

The above hydroxyl group-containing monomer refers to polymerizable monomers containing one or more hydroxyl groups in the monomer structure.

Examples of the above hydroxyl group-containing monomers include 2-hydroxyethyl (meth)acrylate, 3-hydroxypropyl (meth)acrylate, 2-hydroxybutyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, (4-hydroxymethyl cyclohexyl)methyl acrylate, N-methylol (meth)acrylamide, N-hydroxy (meth)acrylamide, vinyl alcohol, allyl alcohol, 2-hydroxyethyl vinyl ether, 4-hydroxybutyl vinyl ether, and diethylene glycol monovinyl ether.
Among these, 4-hydroxybutyl (meth)acrylate and 6- hydroxyhexyl (meth)acrylate are preferred examples of the hydroxyl group-containing monomer.

The above carboxyl group-containing monomer refers to polymerizable monomers having one or more carboxyl groups in the monomer structure.

Examples of the above carboxyl group-containing monomer include acrylic acid, methacrylic acid, carboxyethyl (meth)acrylate, carboxypentyl (meth)acrylate, itaconic acid, maleic acid, fumaric acid, and crotonic acid.
Among these, acrylic acid and methacrylic acid are particularly preferably used.

The acrylic polymer used in the present invention may also use as necessary, as a monomer other than the monomers described above, or a polymerizable monomer, to adjust the glass transition point and peeling properties of the acrylic polymer to within the range in which advantageous effects of the present invention are not adversely affected.

As other polymerizable monomers used in the acrylic polymer of the present invention, components for improving cohesive force and heat resistant properties such as a sulfonic acid group-containing monomer, a phosphoric acid group-containing monomer, a cyano group-containing monomer, a vinyl ester monomer, and an aromatic vinyl monomer, and components having a functional group for improving the bond strength and serving as a crosslinking basal point such as an amide group-containing monomer, an amino group-containing monomer, an imide group-containing monomer, an epoxy group-containing monomer, and a vinyl ether monomer may be used as required.
Further, in the above Formula (1), monomers wherein R² is an alkyl group having 1 carbon atom or 15 or more carbon atoms may be used as necessary.
These monomer compounds may be used singly or in mixture of two or more thereof.

Examples of the sulfonic acid group-containing monomer include styrenesulfonic acid, arylsulfonic acid,
2-(meth)acrylamide-2-methylpropanesulfonic acid,
(meth)acrylamidepropanesulfonic acid, sulfopropyl (meth)acrylate, and (meth)acryloyloxynaphthalenesulfonic acid.
An example of the phosphoric acid group-containing monomer is 2-hydroxyethyl acryloyl phosphate.
Examples of the cyano group-containing monomer include acrylonitrile and methacrylonitrile.
Examples of the vinyl ester monomer include vinyl acetate, vinyl propionate, vinyl laurate, and vinyl pyrrolidone.
Examples of the aromatic vinyl monomer include styrene, chlorostyrene, chloromethyl styrene, and α-methyl styrene.
Examples of the amide group-containing monomer include (meth)acrylamide, N,N-dimethyl (meth)acrylamide, N,N-diethyl (meth)acrylamide, N,N-diethyl methacrylamide, N-isopropyl (meth)acrylamide, N-methylol (meth)acrylamide, N-methoxymethyl (meth)acrylamide, N-butoxymethyl (meth)acrylamide, dimethylaminoethyl (meth)acrylate, t-butylaminoethyl (meth)acrylate, diacetone (meth)acrylamide, N-vinylacetamide, N,N'-methylenebis(meth)acrylamide, N,N-dimethylaminopropyl(meth)acrylamide, N-vinyl caprolactam, and N-vinyl-2- pyrrolidone.
Examples of the amino group-containing monomer include aminoethyl(meth)acrylate, N,N-dimethyl aminoethyl(meth)acrylate, N,N-dimethyl aminopropyl(meth)acrylate, and N-(meth)acryloylmorpholine.
Examples of the imide group-containing monomer include N-cyclohexylmaleimide, N-phenylmaleimide, N-methylmaleimide, N-ethylmaleimide, N-propylmaleimide, N-isopropylmaleimide, N-butylmaleimide, and itaconimide.
Examples of the epoxy group-containing monomer include glycidyl (meth)acrylate, and allylglycidyl ether.
Examples of the vinyl ether monomer include methyl vinyl ether, ethyl vinyl ether, and isobutyl vinyl ether.
Examples of the (meth)acrylic monomer having an alkyl group with 1 or 15 or more carbon atoms include methyl (meth)acrylate, pentadecyl (meth)acrylate, and hexadecyl (meth)acrylate.

Further, the monomers may include other copolymerizable monomers as necessary to enhance properties such as cohesive force. Examples of such other copolymerizable monomers include vinyl compounds such as vinyl acetate, styrene, and vinyl toluene; (meth)acrylic acid esters of cyclic alcohols such as cyclopentyl di(meth)acrylate and isobornyl (meth)acrylate; and (meth)acrylic acid esters of polyvalent alcohols such as neopentylglycol di(meth)acrylate, hexanediol di(meth)acrylate, propylene glycol di(meth)acrylate, trimethylol propane tri(meth)acrylate, tetramethylolmethane tri(meth)acrylate, and dipentaerythritol hexa(meth)acrylate.

The above other polymerizable monomers may be used singly, or in mixture of two or more thereof, but the total content thereof in the entire monomers of the acrylic polymer is preferably 0 to 50% by weight, more preferably 0 to 35% by weight, further preferably 0 to 25% by weight.

Further, the above acrylic polymer preferably has a weight-average molecular weight of 600,000 or more, more preferably 700,000 to 3,000,000, further preferably 800,000 to 2,500,000. When a weight-average molecular weight is less than 600,000, the durability may be affected. On the other hand, the above weight-average molecular weight is preferably 3,000,000 or less in view of the workability. The weight-average molecular weight is in terms of the polystyrene equivalent value of the GPC (gel permeation chromatography) measurement.

The glass transition temperature (Tg) of the above acrylic polymer is -5°C or lower, preferably -10°C or lower, for the reason of easily balancing the bond properties (adhesive properties).
When a glass transition temperature is -5°C or higher, the polymer fluidity is poor causing insufficient wetting of an adherend, whereby the bond strength may be reduced.
The glass transition temperature (Tg) of the acrylic polymer can be adjusted as necessary by changing the acrylic polymer to be used and the composition ratio thereof.

For producing such an acrylic polymer, a process can be suitably selected from the known production processes such as solution polymerization, bulk polymerization, emulsion polymerization, and any radical polymerizations. An acrylic polymer to be obtained may be a homopolymer or a copolymer. When the obtained acrylic polymer is a copolymer, the copolymer may be any of a random copolymer, block copolymer and graft copolymer.

For the solution polymerization, for example, ethyl acetate or toluene is used as a polymerization solvent. As a specific example of the solution polymerization, the reaction is carried out under an inert gas atmosphere such as nitrogen by adding, as a polymerization initiator, for example, 0.01 to 0.2 parts by weight of azobisisobutylonitrile per 100 parts by weight of the entire monomer amount, at typically about 50 to about 70°C for about 8 to about 30 hours.

The polymerization initiator, chain transfer agent, emulsifier used for the radical polymerization are suitably selected for use.

Examples of the polymerization initiator used in the present invention include, azo initiators such as 2,2'-azobisisobutylonitrile, 2,2'-azobis(2-amidinopropane)dihydrochloride,
2,2'-azobis[2-(5-methyl-2-imidazolin-2-yl)propane]dihydrochloride,
2, 2'-azobis(2-methylpropionamidine)disulfate,
2,2'-azobis(N,N'-dimetyleneisobutylamidine), and
2,2'-azobis[N-(2-carboxyethyl)-2-methylpropionamidine]hydrate (VA-057, manufactured by Wako Pure Chemical Industries, Ltd.); persulphates such as potassium persulfate and ammonium persulfate; peroxide initiators such as di(2-ethylhexyl)peroxydicarbonate, di(4-t-butylcyclohexyl)peroxydicarbonate, di-sec-butylperoxydicarbonate, t-butylperoxyneodecanoate, t-hexylperoxypivalate, t-butylperoxypivalate, dirauloyl peroxide, di-n-octanoyl peroxide,
1,1,3,3-tetramethylbutyl peroxy-2-ethyhexanoate, di(4-methylbenzoyl) peroxide, dibenzoyl peroxide, t-butylperoxy isobutyrate, 1,1-di(t-hexylperoxy)cyclohexane, t-butylhydroperoxide, and hydrogen peroxide; a combination of persulphate and sodium hydrogen sulfite; and redox initiators in which peroxide and a reducing agent are combined such as a combination of peroxide and sodium ascorbate.

The above polymerization initiators may be used singly, or in mixture of two or more thereof, but the total content is preferably about 0.005 to about 1 parts by weight, more preferably 0.02 to 0.5 parts by weight, per 100 parts by weight of the monomers.

In the present invention, a chain transfer agent may be used in the polymerization. The use of a chain transfer agent allows suitable adjustment of the molecular weight of the acrylic polymer.

Examples of the chain transfer agent include lauryl mercaptan, glycidyl mercaptans, mercapto-acetic acid, 2-mercaptoethanol, thioglycolic acid, 2-ethylhexyl thioglycolate, and 2,3-dimercapto-1-propanol.

These chain transfer agents may be used singly, or in mixture of two or more thereof, but the total content is 0.01 to 0.1 parts by weight per 100 parts by weight of the monomers.

Examples of the emulsifier used when the emulsion polymerization is carried out include anionic emulsifiers such as sodium lauryl sulfate, ammonium lauryl sulfate, sodium dodecylbenzene sulphonate, ammonium polyoxyethylene alkyl ether sulfate, and sodium polyoxyethylene alkyl phenyl ether sulfate; and nonionic emulsifiers such as polyoxyethylene alkyl ether, polyoxyethylene alkyl phenyl ether, polyoxyethylene fatty acid ester, and polyoxyethylene-polyoxypropylene block polymer. These emulsifiers may be used singly, or in mixture of two or more thereof.

Further, as the reactive emulsifier, emulsifiers having a radical polymerizable functional group such as a propenyl group or an allyl ether group introduced therein may be used, and specific examples include Aqualon® HS-10, HS-20, KH-10, BC-05, BC-10, BC-20 (all manufactured by Dai-ichi Kogyo Seiyaku Co., Ltd.), and Adekariasoap® SE10N (manufactured by ADEKA® Corporation).
The reactive emulsifier is incorporated into a polymer chain after polymerization, resulting in better water resistance, hence preferable.
The amount of emulsifier to be used is, for example, 0.3 to 5 parts by weight, more preferably 0.5 to 1 parts by weight, per 100 parts by weight of the monomer, in view of the polymerization stability and mechanical stability.

The heat conductive adhesive composition of the present invention preferably contains a crosslinking agent for the purpose of improving the bond strength and durability. Examples of the crosslinking agent usable include commonly known crosslinking agents such as isocyanate crosslinking agents, epoxy crosslinking agents, melamine crosslinking agents, oxazoline crosslinking agents, carbodiimide crosslinking agents, aziridine crosslinking agents, and metal chelate crosslinking agents, with isocyanate crosslinking agents being preferably contained.

Examples of the isocyanate crosslinking agent include aromatic isocyanates such as tolylene diisocyanate and xylene diisocyanate; alicyclic isocyanates such as isophorone diisocyanate; and aliphatic isocyanates such as hexamethylene diisocyanate.

More specifically, examples include lower aliphatic polyisocyanates such as butylene diisocyanate and hexamethylene diisocyanate; alicyclic isocyantes such as cyclopentylene diisocyanate, cyclohexylene diisocyanate, and isophorone diisocyanate; aromatic diisocyanates such as 2,4-tolylene diisocyanate, 4,4'-diphenylmethane diisocyanate, xylylene diisocyanate, and polymethylene polyphenyl isocyanate; isocyanate adducts such as trimethylol propane/tolylene diisocyanate trimer adduct (trade name Colonate L®, manufactured by Nippon Polyurethane Kogyo Co.,), trimethylol propane/hexamethylene diisocyanate trimer adduct (trade name Colonate HL®, manufactured by Nippon Polyurethane Kogyo Co.,), and isocyanurate form of hexamethylene diisocyanates (trade name Colonate HX®, manufactured by Nippon Polyurethane Kogyo Co.,); polyether polyisocyanate, polyester polyisocyanate, adducts of these polyisocyanates and various polyols, and polyisocyanates polyfunctionalized with an isocyanurate bond, a biuret bond, or an allophanate bond.

The above crosslinking agents may be used singly, or in mixture of two or more thereof, but the total content of the above crosslinking agents is preferably 0.02 to 5 parts by weight, more preferably 0.04 to 3 parts by weight, further preferably 0.05 to 2 parts by weight, per 100 parts by weight of the base polymers described earlier. When the crosslinking agent is used in an amount within the above range, the enhanced cohesive force and durability are further assured, whereas the crosslinking agent used in an amount of more than 2 parts by weight causes an excessive crosslink formation, likely affecting the bond properties.

In the present invention, the amount of the crosslinking agent to be added is adjusted so that the gel fraction of the crosslinked adhesive layer is preferably 40 to 90% by weight, so that the gel fraction of the crosslinked adhesive layer is more preferably 50 to 85% by weight, so that the gel fraction of the crosslinked adhesive layer is further preferably 55 to 80% by weight. When a gel fraction is less than 40% by weight, the cohesive force is reduced sometimes causing the durability to be poor, whereas when a gel fraction exceeds 90% by weight, the bond properties may be deteriorated.

The gel fraction (% by weight) of the heat conductive adhesive composition of the present invention can be determined by collecting a sample in a dried weight W1 (g) from the adhesive layer, immersing the sample in ethyl acetate, and taking out the insoluble residue of the above sample from ethyl acetate, followed by measuring a dried weight W2 (g) to calculate (W2/W1) x 100.

A silane coupling agent may be used in the heat conductive adhesive composition of the present invention for the purposes of improving the bond strength, durability and affinity between boron nitride particles and the acrylic polymer.
The silane coupling agent may suitably be used.

Specific examples include epoxy group-containing silane coupling agents such as 3-glycidoxypropyl trimethoxysilane, 3-glycidoxypropyl triethoxysilane, 3-glycidoxypropyl methyldiethoxysilane, and
2-(3,4-epoxycyclohexyl)ethyltrimethoxysilane; amino group-containing silane coupling agents such as 3-aminopropyltrimethoxysilane,
N-2-(aminoethyl)-3-aminopropylmethyldimethoxysilane, and 3-triethoxysilyl-N-(1,3-dimethylbutylidene)propylamine; (meth)acryl group-containing silane coupling agents such as 3-acryloxypropyltrimethoxisilane and 3-methacryloxypropyltriethoxysilane; and isocyanate group-containing silane coupling agents such as 3-isocyanatepropyltriethoxysilane. The use of such a silane coupling agent is desirable with respect to enhancing the durability.

The above silane coupling agents may be used singly, or in mixture of two or more thereof, but the total content of the above silane coupling agents is preferably 0.01 to 10 parts by weight, more preferably 0.02 to 5 parts by weight, further preferably 0.05 to 2 parts by weight, per 100 parts by weight of the acrylic polymer described earlier. When the above silane coupling agent is used in an amount within the above range, the enhanced cohesive force and durability are more assured. To the contrary, the silane coupling agent in an amount of below 0.01 parts by weight fails as a filler to coat the surface of boron nitride particles contained in the heat conductive adhesive composition, sometimes causing unimproved affinity, whereas the silane coupling agent in an amount of exceeding 10 parts by weight may reduce heat conductivity.

A tackifier resin may be used in the heat conductive adhesive composition of the present invention for the purposes of improving the bond strength and durability.

The known tackifier resins can be suitably used as the tackifier resin- . Specific examples of the tackifier resin include rosine resins, terpene resins, aliphatic petroleum resins, aromatic petroleum resins, copolymerized petroleum resins, alicyclic petroleum resins, xylene resins, and elastomers.

The above tackifier resin is contained in the heat conductive adhesive composition in an amount to make its proportion at preferably 10 to 100 parts by weight, more preferably 20 to 80 parts by weight, further preferably 30 to 50 parts by weight, per 100 parts by weight of the acrylic polymer.

It is important that the filler contained in the heat conductive adhesive composition of the present invention be boron nitride particles having a particle size of 3 µm or more and 300 µm or less.
It is further important to contain boron nitride particles in the heat conductive adhesive composition so that boron nitride particles having a particle size of 3 µm or more and 20 µm or less account for any proportion of 5 to 45% by volume, preferably 10 to 40% by volume, boron nitride particles having a particle size of more than 20 µm and 60 µm or less account for any proportion of 30 to 70% by volume, preferably 35 to 65% by volume, and boron nitride particles having a particle size of more than 60 µm and 300 µm or less account for any proportion of 10 to 40% by volume, preferably 15 to 35% by volume.

Whether or not boron nitride particles in the above particle size ranges are contained in the above proportions can be verified by measuring the particle size distribution of the boron nitride particles contained in the heat conductive adhesive composition using the laser diffraction technique, determining the total volume (V1) of the boron nitride particles having a particle size of 3 µm or more and 20 µm or less, the total volume (V2) of the boron nitride particles having a particle size of more than 20 µm and 60 µm or less, and the total volume (V3) of the boron nitride particles having a particle size of more than 60 µm and 300 µm or less, and dividing the total volume of boron nitride particles of each range (V1, V2, V3) by the sum of all total volumes (V1 + V2 + V3).

In the heat conductive adhesive composition of the present embodiment, the contents of the boron nitride fillers having the respective particle sizes are defined in the ranges described above. This is because it is hard to provide a molding with good heat conductivity using a heat conductive adhesive composition containing the boron nitride fillers in different conditions from these ranges.
In other words, the boron nitride particles within the above ranges contained in the heat conductive adhesive composition enable the heat conductivity of a molding to be enhanced as compared with the case using the conventional heat conductive adhesive compositions.

The boron nitride particles can be contained in the conditions described above in the heat conductive adhesive composition using boron nitride particles having an average particle size of 60 to 300 µm in an aggregated state, such as granular particles and collective particles, and dispersing the above boron nitride particles in the heat conductive adhesive composition by, for example, the method to be described later while pulverizing the particles.
The "average particle size" can be determined by measuring the D50 value from particle size distribution measurement by the laser diffraction technique.

Using boron nitride particles having an average particle size of 60 to 300 µm in an aggregated state, when the method in which the boron nitride particles are dispersed in the heat conductive adhesive composition while being pulverized by shearing force is employed, the boron nitride particles having a particle size of more than 60 µm and 300 µm or less in the obtained heat conductive adhesive composition are typically dispersed in a state in which the original aggregated state remains unchanged, the boron nitride particles having a particle size of 3 µm or more and 20 µm or less are typically dispersed in a state in which the scaly shape, the primary particle shape of boron nitride, is conserved, and the boron nitride particles having a particle size of more than 20 µm and 60 µm or less are typically dispersed in a state in which the original state (aggregate condition) is broken and the particle size is smaller.

In one embodiment, the proportion of all the boron nitride particles relative to the heat conductive adhesive composition is 10% by volume or more and below 50% by volume. Further, as for the content of the above boron nitride filler in the heat conductive adhesive composition, when the heat conductive adhesive composition is used to form a heat conductive adhesive sheet, the proportion of the boron nitride particles in the heat conductive adhesive sheet (for a heat conductive adhesive sheet with a substrate, the proportion of the boron nitride particles in an adhesive layer) is preferably 10% by volume or more, more preferably 15% or more by volume (and typically less than 50% by volume), further preferably 20 to 45% by volume. When a proportion is below 10% by volume, there is a drawback of failing to attain the heat conductivity, whereas a proportion exceeding 50% by volume, there is a drawback of failing to attain the bond strength.

In the heat conductive adhesive composition used to form an adhesive layer, particles of aluminum nitride, silicon nitride, gallium nitride, aluminum oxide, silicon carbide, silicon dioxide, and diamond, may be added as a filler in addition to the boron nitride particles within the range wherein the advantageous effects of the present invention are not affected.

Furthermore, the heat conductive adhesive composition of the present embodiment may suitably contain, in addition to the above polymer components, nitride particles, products commonly used as additive chemicals in rubbers and plastic such as dispersant, age resister, antioxidant, processing aid, stabilizer, defoaming agent, flame retardant, thickener, and pigment, within the range wherein the advantageous effects of the present invention are not affected, although details are not described herein.

Described subsequently is a method for producing a heat conductive adhesive sheet supported by a substrate using such a heat conductive adhesive composition and a substrate with reference to an example of a method wherein a liquid heat conductive adhesive composition is coated.
Described first is a method for preparing a coating solution (a liquid heat conductive adhesive composition) used for the above coating by containing as a filler the boron nitride particles having an average particle size of 60 to 300 µm in an aggregated state in an acrylic polymer component.

To prepare the above coating solution, a mixer capable of stirring boron nitride particles with an acrylic polymer under reduced pressure is used.
Further, if necessary, a dispersant can be contained in the coating solution for improving the dispersability of the boron nitride filler in an acrylic polymer.
For the dispersant, it is desirable to use those containing a compound having an amine value of more than 0 mg KOH/g and 35 mg KOH/g or less with respect to providing good effect in improving the dispersability of boron nitride filler in an acrylic polymer.

First, boron nitride particles are put in the above mixer, and subsequently a part of a resin solution containing an acrylic polymer and other components dispersed in a solvent is added to the mixer and the mixture is stirred (at room temperature), for example, under reduced pressure of 1 to 20 kPa to carry out the particle size adjustment step, in which the boron nitride particles in an aggregated state are pulverized.

In the particle size adjustment step, the mixture of the filler and the resin solution can be maintained in a highly viscous condition by stirring without feeding the whole amount of the resin solution required to prepare the heat conductive adhesive composition, thereby mixing the mixture while applying a high shear stress.
As a result, the boron nitride particles in an aggregated state subjected to a high shear stress have a loose aggregated state and pulverized to somewhat closer to the primary particle size, for example, pulverized to a particle size of 3 µm or more and 20 µm or less.

More specifically, the particle size adjustment step which can be employed is a method wherein a stirring operation is continued in a mixer at a rotation speed as low as 30 rpm or less, preferably 10 to 20 rpm, until the all boron nitride particles are dispersed in the resin solution and the entire mixture reaches the viscosity to the extent that no adhesion to the stirrer blades is found.

Subsequently, the remaining resin solution is added to the mixture and the mixture of the boron nitride particles and the resin solution prepared in the particles size adjustment step is stirred (at room temperature) under reduced pressure of, for example, 1 to 20 kPa at a viscosity lower than that at the particle size adjustment step to carry out the particle size readjustment step wherein the boron nitride particles are pulverized again.
If necessary, the particle size readjustment step can be carried out stepwise in multiple operations by adding the remaining of resin solution several times.

More specifically, the particle size readjustment step which can be employed is a method in which a stirring operation is continued in a mixer at a rotation speed of 20 to 50 rpm or lower, preferably 20 to 30 rpm, which are higher than that in the particle size adjustment step, until no large aggregates are identified visually.

In this particle size readjustment step, the shear stress is lower than that in the particle size adjustment step and hence boron nitride particles in an aggregated state are not pulverized into very small particle size, i.e., boron nitride particles having a medium particle size of more than 20 µm and 60 µm or less are formed in a higher amount than in the particle size adjustment step.

Thus, by carrying out the particle size adjustment step and one or more particle size readjustment steps, the filler condition in the coating solution is adjusted so as to contain the boron nitride particles having a particle size of 3 µm or more and 300 µm or less, where the boron nitride particles contain 5 to 45% by volume of boron nitride particles having a particle size of 3 µm or more and 20 µm or less, 30 to 70% by volume of the boron nitride particles having a particle size of more than 20 µm and 60 µm or less, and 10 to 40% by volume of the boron nitride particles having a particle size of more than 60 µm and 300 µm or less.

For a method for producing a heat conductive adhesive sheet supported on a substrate using the thus prepared coating solution as described above, routinely practiced conventional coating methods can be used.
For example, the coating solution is applied to a substrate and dried to form an adhesive layer on the substrate, thereby producing a heat conductive adhesive sheet supported on a substrate.
Alternatively, the coating solution is applied to a release film and dried, and the release film is peeled to laminate only the adhesive layer with a substrate, thereby producing a heat conductive adhesive sheet supported on a substrate.

Examples of the method for forming an adhesive layer in the present invention include roll coat, kiss roll coat, photogravure coat, reverse coat, roll brush, spray coat, dip roll coat, bar coat, knife coat, air knife coat, curtain coat, lip coat, and extrusion coating technique using a die coater.

Examples of the substrate used in the present invention include plastic base materials such as polyethylene terephthalate (PET) and polyester film; porous materials such as paper and non-woven cloth; as well as metallic foils.

The plastic base material is capable of forming a sheet and a film, and examples include polyolefin films such as films of polyethylene, polypropylene, poly-1-butene, poly-4-methyl-1-pentene, ethylene-propylene copolymer, ethylene-1-butene copolymer, ethylene-vinyl acetate copolymer, ethylene-ethyl acrylate copolymer, and ethylene-vinyl alcohol copolymer; polyester films such as films of polyethylene terephthalate, polyethylene naphthalate, and polybutylene terephthalate; polyacrylate film; polystyrene film; polyamide films such as films of nylon 6, nylon 6,6, and partial aromatic polyamide; polyvinyl chloride film, polyvinylidene chloride film, and polycarbonate film. The thickness of the above films is typically 4 to 100 µm, preferably 4 to 25 µm.

The plastic base material may also be subjected to, as necessary, release and antifouling treatment using a silicone-, fluorine-, long chain alkyl- or fatty acid amide-based release agent, silica powder; adhesion treatments such as acid treatment, alkali treatment, primer treatment, corona treatment, plasma treatment, and ultraviolet treatment; and antistatic treatment by coating, adding or vapor-depositing.

Examples of the component material for the release film include plastic films such as polyethylene, polypropylene, and polyethylene terephthalate; porous materials such as paper, cloth, and non-woven cloth; and net, foaming sheet, metallic foil, and suitable foliated products such as laminated products thereof, with plastic films being preferably used from viewpoint of good surface smoothness.

The plastic film is capable of protecting the above described adhesive layer, and examples include polyethylene film, polypropylene film, polybutene film, polybutadiene film, polymethyl pentene film, polyvinyl chloride film, vinyl chloride copolymer film, polyethylene terephthalate film, polybutylene terephthalate film, polyurethane film, and ethylene-vinyl acetate copolymer film.

The above release film may be subjected to, as necessary, release and antifouling treatment using a silicone-, fluorine-, long chain alkyl- or fatty acid amide-based release agent, silica powder, and antistatic treatment by coating, adding or vapor-depositing.
In particular, the releasability from the above described adhesive layer is further improved by subjecting the surface of the above release film to suitable release treatments such as silicone treatment, long-chain alkyl treatment, and fluorine treatment.

The thickness of the above release film is typically 5 to 200 µm, preferably 5 to 100 µm.

Further, in the heat conductive adhesive sheet of the present invention, the thickness of the above adhesive layer is preferably 20 µm to 5 mm, more preferably 50 µm to 2 mm, further preferably 100 µm to 1 mm.

According to one embodiment, in the heat conductive adhesive sheet 0.2% weight or more and 20% by weight or less of monomer constituting the acrylic polymer has apolar group. According to another embodiment of the heat conductive adhesive sheet, the proportion of all the boron nitride particles relative to the heat conductive adhesive composition is 10% by volume or more and below 50% by volume. The heat conductive adhesive sheet of the present invention contains an acrylic polymer as the polymer component and has a characteristically high bond strength of, for example, 1.0 N/20 mm or more, preferably 2.0 N/20 mm or more, to an SUS304 steel plate. With a bond strength of 1.0 N/20 mm or more to an SUS304 steel plate, sufficient bonding performance can be exhibited even when the sheet is used as adhered to a heat sink of a semiconductor module.
The "bond strength to SUS304 steel plate" can be measured by the method described in Example.

The heat conductive adhesive sheet of the present invention has a characteristically high heat conductivity because the particle size of the boron nitride particles used as a filler is specified as described earlier, and has a heat conductivity of, for example, 0.5 W/m·K or more, more preferably 1.0 W/m·k or more. With a heat conductivity of 0.5 W/m·K or more, a sufficient heat conductivity can be exhibited even when the sheet is used as adhered to a heat sink of a semiconductor module.

In the present embodiment, the heat conductive adhesive composition is desirably used as a heat conductive adhesive sheet used as adhered to a heat sink of a semiconductor module with respect to remarkably providing the advantageous effects of the present invention, which is to impart a high heat conductivity to a molding with a heat conductive adhesive composition therein, but not limited to such a use alone.
For example, the heat conductive adhesive composition can also be used to produce a heat conductive adhesive sheet which is solely formed from an adhesive layer (heat conductive adhesive composition).
Alternatively, the heat conductive adhesive composition can also be used for purposes other than a heat conductive adhesive sheet.

### EXAMPLE

Hereinafter, the present invention is further described in reference to the examples.

### (Example 1)

### (Preparation of acrylic polymer solution)

Using a reactor vessel equipped with a cooling tube, a nitrogen introduction tube, a thermometer and a stirrer, 100 parts by weight of butyl acrylate, 5 parts by weight of acrylic acid, 0.4 parts by weight of 2,2'-azobisisobutyronitril (initiator) and 210 parts by weight of toluene were charged thereto and the air inside the system was thoroughly replaced with nitrogen gas and heated at 60°C for 6 hours to obtain an acrylic polymer solution having a solid content of 31.0% by weight.

### (Preparation of heat conductive adhesive composition)

Fifty parts by weight of the boron nitride particles (trade name "HP-40", manufactured by MIZUSHIMA FERROALLOY CO., LTD.) and 2 parts by weight of a polyfunctional isocyanate compound (trade name "Colonate L"®, manufactured by NIPPON POLYURETHAN INDUSTRY CO., LTD.) as a crosslinking agent per 100 parts by weight of the above acrylic polymer solution were placed in a "HIGHVIS MIXER"®, manufactured by PRIMIX Corporation, and the mixture was stirred for 30 minutes under reduced pressure to prepare the heat conductive adhesive composition.

### (Production of heat conductive adhesive sheet)

The obtained heat conductive adhesive composition was applied to the release-treated surface of a release film, in which one surface of polyethylene terephthalate was treated with a silicone release agent, so as to give a thickness of 120 µm when dried and dried at 70°C for 15 minutes to produce a heat conductive adhesive sheet.
The proportion of the boron nitride particles in the heat conductive adhesive layer was 18% by volume.

### (Example 2)

A heat conductive adhesive sheet was produced in the same manner as in Example 1 except that 100 parts by weight of boron nitride particles (trade name "HP-40", manufactured by MIZUSHIMA FERROALLOY CO., LTD.) was added to 100 parts by weight of the above acrylic polymer solution.
The proportion of the boron nitride particles in the heat conductive adhesive layer was 31% by volume.

### (Example 3)

A heat conductive adhesive sheet was produced in the same manner as in Example 1 except that 100 parts by weight of boron nitride particles (trade name "HP-40", manufactured by MIZUSHIMA FERROALLOY CO., LTD.) was added to 100 parts by weight of the above acrylic polymer solution and 1.5 parts by weight of a silane coupling agent ("KBM-403", manufacture by Shin-Etsu Chemical Co., Ltd.) was added.
The proportion of the boron nitride particles in the heat conductive adhesive layer was 31% by volume.

### (Example 4)

A heat conductive adhesive sheet was produced in the same manner as in Example 1 except that 150 parts by weight of boron nitride particles (trade name "HP-40", manufactured by MIZUSHIMA FERROALLOY CO., LTD.) was added to 100 parts by weight of the above acrylic polymer solution.
The proportion of the boron nitride particles in the heat conductive adhesive layer was 40% by volume.

### (Comparative Example 1)

A heat conductive adhesive sheet was produced in the same manner as in Example 1 except that no boron nitride powder (trade name "HP-40", manufactured by MIZUSHIMA FERROALLOY CO., LTD.) was used.
The proportion of the boron nitride particles in the heat conductive adhesive layer was 0% by volume.

### (Comparative Example 2)

A heat conductive adhesive sheet was produced in the same manner as in Example 1 except that 50 parts by weight of "PT620", manufactured by MOMENTIVE Performance Material Inc., per 100 parts by weight of the above acrylic polymer solution was used as the boron nitride particle in place of trade name "HP-40", manufactured by MIZUSHIMA FERROALLOY CO., LTD.
The proportion of the boron nitride particles in the heat conductive adhesive layer was 18% by volume.

### (Evaluation)

### (Determination of particle size distribution of boron nitride particle)

The particle size distribution of the boron nitride particles in the heat conductive adhesive composition obtained in each of Examples and Comparative Examples was measured by a laser diffraction technique.
The particle size distribution was measured using a "Microtrac MT-3300 EX II", manufactured by NIKKISO CO., LTD. and ethyl acetate (refractive index = 1.37) as a solvent.
Based on the measurement results, the total volume (V1) of the boron nitride particles having a particle size of 3 µm or more and 20 µm or less, the total volume (V2) of the boron nitride particles having a particle size of more than 20 µm and 60 µm or less, and the total volume (V3) of the boron nitride particles having a particle size of more than 60 µm and 300 µm or less were determined and the total thereof (T(=V1+V2+V3)) was determined.
Further, the total volume of the boron nitride particles of each range (V1, V2, V3) was divided by the sum of all the total volumes (T) to determine the volume % (vol%).
The results are shown in Table 1.

### (Heat conductivity measurement)

Heat conductivity was measured using the heat conductive adhesive sheets produced in each of Examples and Comparative Examples.
The heat conductivity was calculated by determining a heat diffusivity using trade name "ai-phase mobile", manufactured by ai-Phase Co., Ltd., and further measuring a heat capacity per unit volume of the heat conductive adhesive sheet based on the measurement using a differential scanning calorimetry (DSC), which was then multiplied by the heat diffusivity determined earlier.
The results are shown in Table 1.

### (Measurement of adhesive strength)

A PET film having a thickness of 25 µm was laminated with each of the heat conductive adhesive sheet produced in Examples and Comparative Examples and cut into a size of a 20 mm width and a 150 mm length to form samples for evaluation. The release film was peeled off from the evaluation sample and the sample was adhered to an SUS304 steel plate under an atmosphere at 23°C with a RH of 50% using a 2 kg roller by a single reciprocating motion.
The surface of the SUS304 steel plate was subjected to polishing treatment using a 360 grit waterproof abrasive paper before the heat conductive adhesive sheet was adhered, further thoroughly degreased with toluene and subsequently dried for 30 minutes under an atmosphere at 23°C with a RH of 50%.
The SUS304 steel plate to which the heat conductive adhesive sheet was adhered was cured at 23°C for 30 minutes and subjected to the peel test using a tensile tester "TCM-1kNB", Minebea Co., Ltd., at a peeling angle of 180°C and a peeling speed of 300 mm/min to measure the bond strength.

**[Table 1]**

| | | Ex.1 | Ex.2 | Ex.3 | Ex.4 | Comp. Ex.1 | Comp. Ex.2 |
|---|---|---|---|---|---|---|---|
| Acrylic polymer | | 100 | 100 | 100 | 100 | 100 | 100 |
| Boron nitride particles | HP-40 | 50 | 100 | 100 | 150 | 0 | - |
| | PT-620 | - | - | - | - | - | 50 |
| Silane coupling agent | KBM-403 | 0 | 0 | 0 | 1.5 | 0 | 0 |
| Boron nitride content (Vol.%) | | 18 | 31 | 31 | 40 | 0 | 18 |
| Distribution (Vol.%) of boron nitride particle size (x) | 3≤x≤20µm | 29 | 27 | 27 | 28 | - | 60 |
| | 20 < x ≤ 60µm | 41 | 45 | 40 | 53 | - | 39 |
| | 60 < x ≤ 300µm | 30 | 28 | 33 | 19 | - | 1 |
| Heat conductivity (W/m/K) | | 0.8 | 2.1 | 2.5 | 4.1 | 0.2 | 0.3 |
| Bond strength (N/20 mm) | | 8.4 | 3.8 | 3.7 | 1.2 | 9.3 | 7.7 |

The table reveals that the heat conductive adhesive composition containing the boron nitride particles in the specific particle size distribution is capable of forming a molding having good heat conductivity.

## Claims

1. A heat conductive adhesive composition comprising boron nitride particles and an acrylic polymer component,
wherein boron nitride particles having a particle size of 3 µm or more and 300 µm or less are contained as the boron nitride particles, and
wherein the boron nitride particles having a particle size of 3 µm or more and 300 µm or less contain boron nitride particles having a particle size of 3 µm or more and 20 µm or less at the ratio of 5 to 45 % by volume, boron nitride particles having a particle size of more than 20 µm and 60 µm or less at the ratio of 30 to 70 % by volume, and boron nitride particles having a particle size of more than 60 µm and 300 µm or lessat the ratio of 10 to 40 % by volume.

2. The heat conductive adhesive composition according to Claim 1, wherein 0.2% by weight or more and 20% by weight or less of monomer constituting the acrylic polymer has a polar group.

3. The heat conductive adhesive composition according to Claim 1, wherein the proportion of all the boron nitride particles relative to the heat conductive adhesive composition is 10% by volume or more and below 50% by volume.

4. A heat conductive adhesive sheet comprising at least an adhesive layer formed using a heat conductive adhesive composition according to any of claims 1 to 3, the heat conductive adhesive composition comprising boron nitride particles and an acrylic polymer component, wherein boron nitride particles having a particle size of 3 µm or more and 300 µm or less are contained as the boron nitride particles, the boron nitride particles having a particle size of 3 µm or more and 300 µm or less contain borom nitride particles having a particle size of 3 µm or more and 20 µm or less at the ratio of 5 to 45 % by volume, boron nitride particles having a particle size of more than 20 µm and 60 µm or less at the ratio of 30 to 70 % by volume, and boron nitride particles having a particle size of more than 60 µm and 300 µm or less at the ratio of 10 to 40 % by volume.

5. The heat conductive adhesive sheet according to Claim 4, wherein 0.2% by weight or more and 20% by weight or less of monomer constituting the acrylic polymer has a polar group.

6. The heat conductive adhesive sheet according to Claim 4, wherein the proportion of all the boron nitride particles relative to the heat conductive adhesive composition is 10% by volume or more and below 50% by volume.

7. The heat conductive adhesive sheet according to Claim 4, wherein the adhesive layer has a bond strength of 1.0 N/20 mm or more.

8. The heat conductive adhesive sheet according to Claim 4 having a heat conductivity of 0.5 W/m·K or more.

## Patentansprüche

1. Wärmeleitfähige Klebstoffzusammensetzung, umfassend Bornitridteilchen und eine Acrylpolymerkomponente,
wobei die Bornitridteilchen mit einer Teilchengröße von 3 µm oder mehr und 300 µm oder weniger als Bornitridteilchen enthalten sind, und
wobei die Bornitridteilchen mit einer Teilchengröße von 3 µm oder mehr und 300 µm oder weniger Bornitridteilchen mit einer Teilchengröße von 3 µm oder mehr und 20 µm oder weniger mit einem Volumenanteil von 5 bis 45 %, Bornitridteilchen mit einer Teilchengröße von mehr als 20 µm und 60 µm oder weniger mit einem Volumenanteil von 30 bis 70 % und Bornitridteilchen mit einer Teilchengröße von mehr als 60 µm und 300 µm oder weniger mit einem Volumenanteil von 10 bis 40 % enthalten.

2. Wärmeleitfähige Klebstoffzusammensetzung nach Anspruch 1, wobei 0,2 Ge-wichts-% oder mehr und 20 Gewichts-% oder weniger des Monomers, aus dem das Acrylpolymer gebildet wird, eine polare Gruppe aufweisen.

3. Wärmeleitfähige Klebstoffzusammensetzung nach Anspruch 1, wobei der gesamte Anteil an Bornitridteilchen im Vergleich zu der wärmeleitfähigen Klebstoffzusammensetzung 10 Volumen-% oder mehr und weniger als 50 Volumen-% beträgt.

4. Wärmeleitfähige Klebstofffolie, umfassend wenigstens eine aus der wärmeleitfähigen Klebstoffzusammensetzung nach einem der Ansprüche 1 bis 3 gebildete Klebstoffschicht, wobei die wärmeleitfähige Klebstoffzusammensetzung Bornitridteilchen und eine Acrylpolymerkomponente umfasst, wobei die Bornitridteilchen mit einer Teilchengröße von 3 µm oder mehr und 300 µm oder weniger als Bornitridteilchen enthalten sind, die Bornitridteilchen mit einer Teilchengröße von 3 µm oder mehr und 300 µm oder weniger Bornitridteilchen mit einer Teilchengröße von 3 µm oder mehr und 20 µm oder weniger mit einem Volumenanteil von 5 bis 45 %, Bornitridteilchen mit einer Teilchengröße von mehr als 20 µm und 60 µm oder weniger mit einem Volumenanteil von 30 bis 70 % und Bornitridteilchen mit einer Teilchengröße von mehr als 60 µm und 300 µm oder weniger mit einem Volumenanteil von 10 bis 40 % enthalten.

5. Wärmeleitfähige Klebstofffolie nach Anspruch 4, wobei 0,2 Gewichts-% oder mehr und 20 Gewichts-% oder weniger des Monomers, aus dem das Acrylpolymer gebildet wird, eine polare Gruppe aufweisen.

6. Wärmeleitfähige Klebstofffolie nach Anspruch 4, wobei der gesamte Anteil an Bornitridteilchen im Vergleich zu der wärmeleitfähigen Klebstoffzsammensetzung 10 Volumen-% oder mehr und weniger als 50 Volumen-% beträgt.

7. Wärmeleitfähige Klebstofffolie nach Anspruch 4, wobei die Klebstoffschicht eine Haftfestigkeit von 1,0 N/20 mm oder mehr aufweist.

8. Wärmeleitfähige Klebstofffolie nach Anspruch 4, die eine Wärmeleitfähigkeit von 0,5 W/m·K oder mehr aufweist.

## Revendications

1. Composition adhésive thermoconductrice comprenant des particules de nitrure de bore et un composant de polymère acrylique,
dans laquelle des particules de nitrure de bore ayant une taille particulaire de 3 µm ou plus et 300 µm ou moins sont contenues en tant que particules de nitrure de bore, et
dans laquelle les particules de nitrure de bore ayant une taille particulaire de 3 µm ou plus et 300 µm ou moins contiennent des particules de nitrure de bore ayant une taille particulaire de 3 µm ou plus et 20 µm ou moins au rapport de 5 à 45 % en volume, des particules de nitrure de bore ayant une taille particulaire de plus de 20 µm et de 60 µm ou moins au rapport de 30 à 70 % en volume, et des particules de nitrure de bore ayant une taille particulaire de plus de 60 µm et de 300 µm ou moins au rapport de 10 à 40 % en volume.

2. Composition adhésive thermoconductrice selon la revendication 1, dans laquelle 0,2 % en poids ou plus et 20 % en poids ou moins de monomère constituant le polymère acrylique ont un groupe polaire.

3. Composition adhésive thermoconductrice selon la revendication 1, dans laquelle la proportion de l'ensemble des particules de nitrure de bore par rapport à la composition adhésive thermoconductrice est de 10 % en volume ou plus et inférieure à 50 % en volume.

4. Feuille adhésive thermoconductrice comprenant au moins une couche adhésive formée en utilisant une composition adhésive thermoconductrice selon l'une quelconque des revendications 1 à 3, la composition adhésive thermoconductrice comprenant des particules de nitrure de bore et un composant de polymère acrylique, dans laquelle des particules de nitrure de bore ayant une taille particulaire de 3 µm ou plus et 300 µm ou moins sont contenues en tant que particules de nitrure de bore, les particules de nitrure de bore ayant une taille particulaire de 3 µm ou plus et 300 µm ou moins contiennent des particules de nitrure de bore ayant une taille particulaire de 3 µm ou plus et 20 µm ou moins au rapport de 5 à 45 % en volume, des particules de nitrure de bore ayant une taille particulaire de plus de 20 µm et de 60 µm ou moins au rapport de 30 à 70 % en volume, et des particules de nitrure de bore ayant une taille particulaire de plus de 60 µm et de 300 µm ou moins au rapport de 10 à 40 % en volume.

5. Feuille adhésive thermoconductrice selon la revendication 4, dans laquelle 0,2 % en poids ou plus et 20 % en poids ou moins de monomère constituant le polymère acrylique ont un groupe polaire.

6. Feuille adhésive thermoconductrice selon la revendication 4, dans laquelle la proportion de l'ensemble des particules de nitrure de bore par rapport à la composition adhésive thermoconductrice est de 10 % en volume ou plus et inférieure à 50 % en volume.

7. Feuille adhésive thermoconductrice selon la revendication 4, dans laquelle la couche adhésive a une résistance d'adhésion de 1,0 N/20 mm ou plus.

8. Feuille adhésive thermoconductrice selon la revendication 4 ayant une conductivité thermique de 0,5 W/m·K ou plus.
